Europäisches Patentamt

European Patent Office

Office européen des brevets

(19)

(11) Veröffentlichungsnummer: **0 144 880**
**A2**

(12) # EUROPÄISCHE PATENTANMELDUNG

(21) Anmeldenummer: 84114220.1

(22) Anmeldetag: 24.11.84

(51) Int. Cl.⁴: **G 03 F 7/08**

(30) Priorität: 07.12.83 DE 3344202

(43) Veröffentlichungstag der Anmeldung:
19.06.85 Patentblatt 85/25

(84) Benannte Vertragsstaaten:
AT CH DE FR GB IT LI NL SE

(71) Anmelder: Merck Patent Gesellschaft mit beschränkter
Haftung
Frankfurter Strasse 250
D-6100 Darmstadt(DE)

(72) Erfinder: Haas, Günther, Dr.
Südring 59
D-6947 Laudenbach(DE)

(72) Erfinder: Neisius, Karl Heinz, Dr.
Kattreinstrasse 76
D-6100 Darmstadt(DE)

(54) Positiv-Fotoresistzusammensetzungen.

(57) Positiv arbeitende Fotoresistzusammensetzungen auf
Basis von Phenol-Formaldehyd-Kondensaten vom Novolaktyp als Harzkomponente mit erhöhter Dimensionsstabilität
und Plasmaätzresistenz werden erhalten, wenn die Harzkomponente eine hohe mittlere Molmasse und einen niedrigen
Polydispersitätsgrad aufweist.

EP 0 144 880 A2

Merck Patent Gesellschaft
mit beschränkter Haftung
D a r m s t a d t

Positiv-Fotoresistzusammensetzungen

Die Erfindung betrifft Positiv-Fotoresistzusammensetzungen für die Herstellung von Reliefstrukturen mit erhöhter Dimensionsstabilität und Plasmaätzresistenz.

Als positiv arbeitende Fotoresistmaterialen, beispielsweise bei der Fertigung von Halbleiter-Bauelementen und elektronischen Schaltungen, werden heute überwiegend lichtempfindliche Zusammensetzungen verwendet, die im wesentlichen aus Phenol-Formaldehyd-Kondensaten vom Novolaktyp als Harzkomponente und Verbindungen vom Typ der o-Diazochinone als lichtempfindliche Komponente bestehen. Fotoresistzusammensetzungen dieser Art sind in zahlreichen Patentschriften beschrieben, von denen beispielhaft die Patentschriften DE-PS 11 95 166/USP 3,201,239 und die deutsche Patentanmeldung P 34 20 816 genannt seien.

Positiv-Fotoresists werden auf die Substratoberfläche in dünner Schicht aufgebracht und dienen nach der z. B. durch eine Maskenvorlage vorgenommenen Belichtung und der Entwicklung, bei der die belichteten Schichtbereiche vom Substrat entfernt werden, zur Strukturierung des Substrates, z. B. durch Ätzen oder Galvanisieren.

Die ständig fortschreitende Miniaturisierung in der Halbleiter-Technologie und Mikroelektronik stellt an die mit Hilfe von Fotoresistmaterialien darzustellenden Bildstrukturen immer höhere Anforderungen, insbesondere hinsichtlich Auflösung von Feinstrukturen und deren Dimensionsstabilität. Der Dimensionsstabilität der mit Fotoresistmaterialien erzeugten Reliefstrukturen kommt heute besondere Bedeutung zu. Zur Erhöhung der mechanischen Festigkeit und Verbesserung der Haftung der Resistschicht auf dem Substrat empfehlen sich in den Verarbeitungsprozessen der Resistmaterialen spezielle Temper- und Härtungsschritte. Zur Erzielung der geforderten Eigenschaften sollten möglichst hohe Temperaturen angewendet werden können, ohne daß hierbei Fließvorgänge in der Resistschicht auftreten, die zu Veränderungen und Verzerrungen der Resiststrukturen bis hin zur Zerstörung der erzeugten Bildmuster führen. Gerade bei der Erzeugung von feinsten hochaufgelösten Strukturen, wie sie in der Mikroelektronik angestrebt werden, gewinnen solche durch Einwirkung erhöhter Temperatur ausgelöste Fließvorgänge einen äußerst unerwünschten Einfluß, da hierbei schon geringste Veränderungen der Geometrie des Reliefbildes stark ins Gewicht fallen.

Zur Erzeugung von feinsten Strukturen im Substrat wird heute in zunehmendem Maße das Verfahren des Plasmaätzens angewendet. Verfahren des Plasmaätzens sind beispielsweise beschrieben in Paulsen, J. Vac. Sci. Technical, 14, 266-274 (1977). Gegenüber der bislang üblichen Naßätzung, bei der eine Verbreiterung der in das Substrat geätzten Struktur gegenüber der durch das Reliefbild des Fotoresists vorgegebenen nicht zu vermeiden ist, ist durch dieses Verfahren eine wesentlich exaktere Strukturierung möglich. Allerdings müssen bei der Anwendung des Plasmaätzens an die Stabilität des eingesetzten Fotoresistmaterials erhöhte Anforderungen hinsichtlich der Plasmaätzresistenz und Temperaturstabilität gestellt werden. Der Schichtabtrag an der Resistschicht - ein äußerst unerwünschter Effekt während des Plasmaätzens - sollte so gering wie möglich gehalten werden.

Darüberhinaus können während des Plasmaätzprozesses in der Ätzkammer Temperaturen von deutlich mehr als 150 °C entstehen. Unabhängig von vorangegangenen Temperschritten dürfen Resistmaterialien, bei denen dieses Verfahren zu Anwendung kommen soll, unter den Bedingungen des Plasmaätzens keine Fließvorgänge zeigen.

Die bekannten Positiv-Fotoresistzusammensetzungen auf Basis von Novolakharzen weisen jedoch eine ungenügende Fließbeständigkeit bei erhöhter Temperatur sowie eine nicht ausreichende Plasmaätzresistenz auf.

Der Erfindung lag somit die Aufgabe zugrunde, Positiv-Fotoresistzusammensetzungen mit hinsichtlich Dimensionsstabilität und Plasmaätzresistenz verbesserten Eigenschaften bereit zu stellen.

Es wurde gefunden, daß man positiv arbeitende Fotoresistzusammensetzungen auf Basis von Phenol-Formaldehyd-
Kondensaten vom Novolaktyp als Harzkomponente mit ausgezeichneter Fließbeständigkeit und hervorragender Plasmaätzresistenz erhält, wenn die darin enthaltene Novolakharzkomponente eine hohe mittlere Molmasse und einen
niedrigen Polydispersitätsgrad aufweist.

Gegenstand der Erfindung sind somit positiv arbeitende
Fotoresistzusammensetzungen auf Basis von Phenol-Formaldehyd-Kondensaten vom Novolaktyp als Harzkomponente,
in der die Harzkomponente eine hohe mittlere Molmasse
und einen niedrigen Polydispersitätsgrad aufweist.

Gegenstand der Erfindung ist weiterhin die Verwendung
von Phenol-Formaldehyd-Kondensaten vom Novolaktyp,
die eine hohe mittlere Molmasse und einen niedrigen
Polydispersitätgrad aufweisen, als Harzkomponente in
positiv arbeitenden Fotoresistzusammensetzungen.

Gegenstand der Erfindung ist darüber hinaus ein Verfahren zur Herstellung von Reliefstrukturen durch Beschichtung eines Substrates mit einer positiv arbeitenden Fotoresistzusammensetzung, Trocknen und bildmäßiges
Belichten der Fotoresistschicht, Ablösen der belichteten
Schichtteile und gegebenenfalls anschließendes Tempern
der erhaltenen Reliefstrukturen, wobei Fotoresistzusammensetzungen verwendet werden, in denen die Novolakharzkomponente eine hohe mittlere Molmasse und
einen niedrigen Polydispersitätsgrad aufweist.

Obwohl Novolakharze bereits in Fotoresistmaterialien eingesetzt wurden, sind dem Stand der Technik kaum detaillierte Angaben über deren physikalische Eigenschaften und Stoffparameter zu entnehmen. Allgemein wird lediglich auf Handelsprodukte oder auf nach allgemein bekannten Herstellungsverfahren erhaltene Harze verwiesen, ohne genauere Daten dieser Materialien zu nennen. Handelsübliche oder nach bekannten Verfahren hergestellte Novolakharze besitzen normalerweise eine relativ niedrige mittlere Molmasse und insbesondere eine hohe Polydispersität - also eine breite Molmassenverteilung.

Novolakharze sind bekanntlich Polykondensate aus aliphatischen Aldehyden oder Ketonen mit Phenolen, substituierten Phenolen oder phenolische Hydroxylgruppen tragenden Verbindungen. Vorzugsweise handelt es sich um Polykondensate von Formaldehyd mit Phenol oder Kresol, die in Gegenwart von Säuren entstehen.

Die erfindungsgemäß zu verwendenden Novolakharze besitzen eine hohe mittlere Molmasse und niedrige Polydispersität, und weisen z. B. eine mittlere Molmasse zwischen 4500 und 18000 auf; ihr Polydispersitätsgrad liegt in Abhängigkeit von der Molmasse zwischen 2,7 (für eine Molmasse von 4500) und 5,7 (für eine Molmasse von 18000). Bevorzugt sind Harze mit einer Molmasse zwischen 7000 und 13000 und einem Polydispersitätsgrad zwischen 2,8 und 4,5.

Die Herstellung der Novolakharze erfolgt zunächst in an sich bekannter Weise durch Kondensation der entsprechenden Phenolderivate mit Aldehyden oder Ketonen. Hierbei läßt man die genannten Ausgangsprodukte bei erhöhter Temperatur und gegebenenfalls in Gegenwart gängiger Kondensationskatalysatoren und/oder wasserbindenen Mitteln reagieren, wobei üblicherweise Novolakharze breiter Molmassenverteilung anfallen. Von diesen zunächst erhaltenen unspezifischen Polykondensaten werden dann die erfindungsgemäß zu verwendenden Novolake mit hoher mittlerer Molmasse und niedrigem Polydispersitätsgrad von Oligomeren und Anteilen mit niedriger Molmasse abgetrennt. Dies kann beispielsweise nach Art einer fraktionierten Fällung erfolgen. Hierzu wird das in der Kondensationsreaktion erhaltene Polykondensat in einem geeigneten Lösungsmittel, gegebenenfalls bei erhöhter Temperatur, gelöst, und durch Zugabe eines Fällungsmittels werden die höhermolekularen Anteile des Polykondensates fraktioniert gefällt. Durch beispielsweise successive Zugabe des Fällungsmittels und Abtrennung der gefällten Fraktionen können die Harzfraktionen mit der gewünschten mittleren Molmasse und mit enger Molmassenverteilung erhalten werden. Es kann aber auch die Lösung des Polykondensates zu einem Fällungsmittel gegeben werden, wobei je nach Wahl der Bedingungen die gewünschten höhermolekularen Anteile gefällt werden und niedermolekulare Anteile in Lösung bleiben. Als Lösungsmittel bei diesen Prozessen kommen alle organischen Solventien in Frage, in denen Novolakharze mäßig bis gut löslich sind. Vorzugsweise wird die fraktionierte Fällung der erfindungsgemäßen Harze aus einer Lösung in 2-Ethoxyethylacetat vorgenommen. Als Fällungsmittel sind organische Flüssigkeiten geeignet, in denen Novolake nicht oder nur schwerlöslich sind. Bevorzugt sind Aromaten wie Benzol, Toluol oder Xylol. Günstig kann es auch sein, die Fällung bei unterschiedlichen, gegebenenfalls erhöhten Temperaturen, vorzugsweise zwischen 60 und 90 $^{o}$C, vorzunehmen.

Der Fachmann kann problemlos durch einfaches Ausprobieren die für ihn günstigen Bedingungen für die fraktionierte Fällung der erwünschten Novolakharzfraktionen ermitteln.

Mittlere Molmasse und Polydispersitätsgrad der erhaltenen Novolakharzfraktionen lassen sich in bekannter Weise durch Gelpermeationschromatographie und Vergleich mit Eichstandards ermitteln.

Die Formulierung der erfindungsgemäßen Novolakharze mit hoher mittlerer Molmasse und niedrigem Polydispersitätsgrad zusammen mit lichtempfindlichen Komponenten zu positiv arbeitenden Fotoresistzusammensetzungen erfolgt in an sich bekannter Weise durch Mischen bzw. Lösen der Komponenten in einem geeigneten Lösungsmittel, gegebenenfalls unter Hinzufügung weiterer in der Technologie der Positiv-Resists üblicher Hilfs- oder Zusatzstoffe. Als lichtempfindliche Komponenten können alle in dieser Technologie bekannten Verbindungen eingesetzt werden, insbesondere diejenigen vom Typ der o-Diazochinone. Bevorzugt sind Naphthochinon-diazidsulfonylderivate, wie sie beispielsweise in den Patentschriften DE-PS 93 82 33/ USP 3,106,465, DE-PS 11 95 166/USP 3,201,239 und der deutschen Patentanmeldung P 32 20 816 beschrieben sind. Besonders bevorzugt sind Veresterungsprodukte von 5-Oxo-6-diazo-5,6-dihydronaphthalinsulfonsäure mit 2,3,4-Trihydroxybenzophenon, Phloroglucin, Resorcin und Gallussäureestern.

Die Anwendung der erfindungsgemäßen Positiv-Fotoresistzusammensetzungen erfolgt in bekannter Weise. Auf das Substrat, beispielsweise ein Silicium-Wafer, wird nach einer der üblichen Beschichtungsverfahren, etwa durch Schleuderbeschichten, die Resistzusammensetzung aufgebracht. Die Schicht wird getrocknet, durch eine Maskenvorlage bildmäßig belichtet und mit Hilfe eines gängigen alkalischen Entwicklers werden die belichteten Schichtbereiche vom Substrat entfernt. Das verbleibende Reliefbild kann nun zur Erzielung einer höheren mechanischen Festigkeit und zur Verbesserung der Haftung auf dem Substrat in nachfolgenden Temperschritten höheren Temperaturen ausgesetzt werden. Positiv-Resistzusammensetzungen nach dem Stand der Technik, die Novolakharze mit relativ niedriger mittlerer Molmasse von insbesondere hoher Polydispersität enthalten, überstehen hierbei bestenfalls Temperaturen bis ca. 150 $^\circ$C ohne merkliche Veränderung der Bildstrukturen. Die hierbei erreichbare Härtung und Haftungsverbesserung ist für die heutigen Ansprüche nicht ausreichend. Der besondere Vorteil der erfindungsgemäßen Photoresistzusammensetzungen ist der, daß in diesen Temperschritten wesentlich höhere Temperaturen, etwa zwischen 160 und 200 $^\circ$C, angewendet werden können, ohne daß es zu Fließvorgängen und Änderungen der Geometrie der erzeugten Bildmuster in der Resistschicht kommt.

Die Vorteile der mit Hilfe der erfindungsgemäßen Fotoresistzusammensetzungen hergestellten Reliefstrukturen zeigen sich insbesondere auch bei dem Vorgang des Plasmaätzens in einer erhöhten Ätzresistenz sowie in einer verbesserten Dimensionsstabilität.

Bei der Strukturierung des Substrates durch Ätzung läßt sich die höchste Wiedergabetreue der durch das Reliefbild des Fotoresists vorgegebenen Struktur mit Hilfe des Plasmaätzens erreichen. Allerdings sind hierbei an Resistbeschichtungen mit Fotoresistzusammensetzungen nach dem Stand der Technik ein unerwünscht hoher Schichtabtrag sowie unerwünschte Fließvorgänge zu beobachten. Diese Vorgänge beeinträchtigen in hohem Maße die verbleibende Schichtdicke sowie die Dimensionsstabilität des Reliefbildes und damit auch entscheidend die Genauigkeit der Übertragung des durch das Reliefbild vorgegebenen Musters auf den Wafer.

Resistschichten und Reliefstrukturen, die aus erfindungsgemäßen Positiv-Fotoresistzusammensetzungen hergestellt wurden, zeigen während der Plasmaätzung deutlich niedrigere Ätzraten als die bekannten Positiv-Resistbeschichtungen. Dimensionsveränderungen, beispielsweise Ineinanderfließen von einzelnen Resistbalken, Abrundung der rechtwinkligen Ecken und Einschrägung oder Verlust der senkrechten Kanten des Resistbildes, sind nicht zu beobachten.

Beispiel 1

Novolakharz:

Man läßt eine Mischung aus 811 g m-Kresol, 11,8 g Oxalsäure, 579 g 35 %ige wäßrige Formaldehydlösung und 125 ml Wasser 2 Stunden am Rückfluß reagieren. Danach wird mit 10 %iger wäßriger Natriumhydrogencarbonatlösung neutralisiert. 1,25 l 2-Ethoxyethylacetat werden zugegeben und das in der Reaktion entstandene Wasser wird durch Destillation entfernt. Die Reaktionsmischung wird nun mit 5,2 g Oxalsäure und 10,25 g Paraformaldehyd versetzt und 2 Stunden bei 110 °C gerührt. Anschließend wird mit 10 %iger wäßriger Natriumhydrogencarbonatlösung neutralisiert und unter vermindertem Druck ein Gemisch aus Wasser und 2-Ethoxyethylacetat abdestilliert, bis sich im Destillat kein Wasser mehr abtrennt. Durch Zugabe von insgesamt 6 l Toluol zu der auf 80 °C erwärmten Reaktionslösung scheidet man das Novolakharz in Form eines flockigen Niederschlages fraktioniert ab. Das Novolakharz wird isoliert und in 2-Ethoxyethylacetat zu einer ca. 30 - 35 %igen Lösung gelöst.

Die Bestimmung von Molmasse und Polydispersitätsgrad erfolgt durch Gelpermeationschromatographie und Vergleich mit einer mit Polystyrolstandards erhaltenen Eichkurve.

Das erhaltene Harz weist eine mittlere Molmasse von 4900 und einen Polydispersitätsgrad von 2,7 auf.

Beispiel 2

Novolakharz:

Man arbeitet nach der in Beispiel 1 gegebenen Vorschrift mit folgenden Abänderungen bei der Kondensation mit Paraformaldehyd:

| | |
|---|---|
| Paraformaldehyd | 6,25 g |
| Oxalsäure | 5,0 g |
| Reaktionstemperatur | 110 °C |
| Reaktionszeit | 5 Stunden |

Man erhält ein Novolakharz mit einer mittleren Molmasse von 7300 und einem Polydispersitätsgrad von 3,3.

Positiv-Fotoresistzusammensetzung:

In der wie vorstehend erhaltenen Lösung des Novolakharzes in 2-Ethoxyethylacetat werden 27 g eines Veresterungsproduktes von 5-Oxo-6-diazo-5,6-dihydro-
naphthalinsulfonsäure und 2,3,4-Trihydroxybenzophenon
(erhalten nach Beispiel 2 der deutschen Patentanmeldung P 32 30 816) gelöst. Nach Verdünnung mit 60 ml
des genannten Lösungsmittels und Filtration ist die
lichtempfindliche Zusammensetzung gebrauchsfertig.

Beispiel 3

Novolakharz:

Ein Novolakharz mit einer mittleren Molmasse von 8500
und einem Polydispersitätsgrad von 3,7 wird erhalten,
wenn wie in Beispiel 1 verfahren wird jedoch mit dem
Unterschied, daß die Reaktionstemperatur bei der Umsetzung mit Paraformaldehyd 130 $^{O}$C beträgt.

Positiv-Fotoresistzusammensetzung:

Eine lichtempfindliche Zusammensetzung wird wie in
Beipiel 2 beschrieben zubereitet.

Beispiel 4

Novolakharz:

Man läßt eine Mischung aus 324 g m-Kresol, 4,7 g Oxalsäure und 231 g 35 %ige wäßrige Formaldehydlösung eine
Stunde bei 90 $^{O}$C reagieren. Anschließend werden 2,4 g
85 %ige Phosphorsäure zugegeben und das Wasser wird
unter vermindertem Druck weitestgehend abdestilliert.

Der erhaltene Rückstand wird in 500 ml 2-Ethoxyethylacetat gelöst und das restliche enthaltene Wasser wird durch Kochen am Wasserabscheider abgetrennt. Zu der erhaltenen Lösung gibt man 4,5 g Paraformaldehyd und rührt 2 Stunden bei 125 $^{\circ}$C. Anschließend gibt man die Reaktionsmischung unter Rühren in 2,5 l Toluol von 70 $^{\circ}$C und trennt das ausgefallene Novolakharz ab. Das erhaltene Harz wird in 2-Ethoxyethylacetat zu einer 30 - 35 %igen Lösung gelöst. Man erhält eine Lösung eines Novolakharzes mit einer mittleren Molmasse von 10300 und einem Polydispersitätsgrad von 4,0.

Positiv-Fotoresistzusammensetzung:

Eine lichtempfindliche Zusammensetzung wird wie in Beispiel 2 beschrieben hergestellt.

Beispiel 5 (Vergleichsbeispiel)

Positiv-Fotoresistzusammensetzung mit einem konventionellen Novolakharz großer Polydispersität zum Vergleich:

Unter Verwendung eines Novolakharzes mit einer mittleren Molmasse von 7400 und einem Polydispersitätsgrad von 8,2 wird analog Beispiel 2 eine lichtempfindliche Zusammensetzung hergestellt.

Beispiel 6

Prüfung von Temperaturbeständigkeit und Plasmaätzverhalten von mit den vorgenannten Fotoresistzusammensetzungen erzeugten Reliefbildern:

Die gemäß den Beispielen 2 - 5 hergestellten lichtempfindlichen Zusammensetzungen werden durch Aufschleudern auf an der Oberfläche thermisch oxidierte Silicium-Wafer in einer 1 µm-dicken Schicht aufgetragen. Nach 30-minütigem Vortrocknen bei 90 °C werden die Wafer im Kontaktbelichtungsverfahren durch eine Maske belichtet. Nach der Belichtung werden die Wafer für 35 Sekunden bei Raumtemperatur mit einem handelsüblichen wäßrigalkalischen Entwickler im Tauchverfahren entwickelt.

Die so erhaltenen Reliefbilder werden durch stufenweises allmähliches Erhitzen jeweils 30 min auf Temperaturbeständigkeit geprüft. Es wird dabei diejenige Temperatur bestimmt, bei der durch Fließvorgänge Verzerrungen der Bildgeometrie an der Grenzfläche Wafer/Resistschicht erstmals auftreten. Die Ergebnisse werden in Tabelle 1 wiedergegeben.

Die mit den Reliefbildern versehenen Siliciumwafer werden in einer handelsüblichen Plasmaätzapparatur mit parallelen Platten geätzt. Der Plattenabstand beträgt 40 mm, das angelegte elektrische Wechselfeld 13,5 MHz bei einer Leistung von 200 Watt. Die Wafer werden auf die untere, waagrechte Kondensatorplatte aufgelegt, die Ätzkammer evakuiert, das Ätzgas (96 % $CF_4$ und 4 % $O_2$) eingelassen und bei konstantem Gasfluß ein Druck von 0,2 Torr in der Ätzkammer eingestellt. Durch Anlegen des elektrischen Wechselfeldes wird das reaktive Ätzplasma erzeugt.

Die verbleibende Schichtdicke des aus dem jeweiligen Resistmaterial bestehenden Reliefbildes wird in Abhängigkeit von der Ätzzeit bestimmt. Daraus wird der Schichtdickenverlust pro Zeiteinheit in $\overset{o}{A}$/min. berechnet, der in Tabelle 1 angegeben ist.

Desweiteren werden die Reliefbilder nach dem Ätzvorgang mikroskopisch daraufhin untersucht, ob während des Ätzens Dimensionsänderungen durch Fließvorgänge bei den sich während des Ätzprozesses aufbauenden Temperaturen auftreten (Prüfung an verschiedenen Bildgeometrien mit 1 und 1,5 μm Linienabstand). Die Ergebnisse sind ebenfalls aus Tabelle 1 ersichtlich.

Tabelle 1

| Zusammensetzung nach Beispiel | Temperaturbelastung ohne Verzerrung bis | Schichtdicken-verlust in $\overset{o}{A}$/min | Verzerrungen der Bildgeometrie |
|---|---|---|---|
| 2 | 180 °C | 200 | nein |
| 3 | 185 °C | 210 | nein |
| 4 | 200 °C | 180 | nein |
| 5 (Vergleich) | 150 °C | 270 | ja |

0144880

Merck Patent Gesellschaft
mit beschränkter Haftung
D a r m s t a d t

Patentansprüche

1. Positiv arbeitende Fotoresistzusammensetzungen auf
Basis von Phenol-Formaldehyd-Kondensaten vom Novolaktyp als Harzkomponente, dadurch gekennzeichnet,
daß die Harzkomponente eine hohe mittlere Molmasse
und einen niedrigen Polydispersitätsgrad aufweist.

2. Positiv arbeitende Fotoresistzusammensetzungen nach
Anspruch 1, dadurch gekennzeichnet, daß die Harzkomponente eine mittlere Molmasse zwischen 4500
und 18000, vorzugsweise zwischen 7000 und 13000,
und einen Polydispersitätsgrad zwischen 2,5 und 5,7,
vorzugsweise zwischen 2,8 und 4,5, aufweist.

3.  Verwendung von Phenol-Formaldehyd-Kondensaten vom
    Novolaktyp, die eine hohe mittlere Molmasse und
    einen niedrigen Polydispersitätsgrad aufweisen, als
    Harzkomponente in positiv arbeitenden Fotoresistzusammensetzungen.

4.  Verfahren zur Herstellung von Reliefstrukturen
    durch Beschichtung eines Substrates mit einer positiv
    arbeitenden Fotoresistzusammensetzung, Trocknen
    und bildmäßiges Belichten der Fotoresistschicht,
    Ablösen der belichteten Schichtteile und gegebenenfalls anschließendes Tempern der erhaltenen
    Reliefstrukturen, dadurch gekennzeichnet, daß
    Fotoresistzusammensetzungen nach den Ansprüchen 1
    und 2 verwendet werden.